# EUROPEAN PATENT SPECIFICATION

(11) **EP 0 513 988 B1**
(45) Date of publication and mention of the grant of the patent: **09.07.1997**
(21) Application number: 92302929.2
(22) Date of filing: 03.04.1992
(51) Int. Cl.: H01L 27/108, H01L 21/8242

(54) **Method of producing capacitive element for dram**
Herstellungsverfahren eines Kondensatorelementes für ein DRAM
Procédé de fabrication d'un élément capacitif pour une DRAM

(30) Priority: 05.04.1991 JP 72688/91
(43) Date of publication of application: 19.11.1992
(73) Proprietor: NEC CORPORATION, Tokyo (JP)
(72) Inventor: Takeuchi, Kiyoshi, Minato-ku, Tokyo (JP)
(74) Representative: Jackson, David Spence

(56) References cited:
- US-A- 4 899 203
- PATENT ABSTRACTS OF JAPAN, vol. 14, no. 374 (E-964), 13 August 1990; & JP-A-2 135 771
- PATENT ABSTRACTS OF JAPAN, vol. 9, no. 106 (E-313)[1829], 10 May 1985; JP-A-59 231 851
- PATENT ABSTRACTS OF JAPAN, vol. 13, no. 201 (E-757)[3549], 12 May 1989; & JP-A-1 022 057
- PATENT ABSTRACTS OF JAPAN, vol. 14, no. 394 (E-969)[4337], 24 August 1990; & JP-A-2 146 765
- PATENT ABSTRACTS OF JAPAN, vol. 13, no. 246 (E-769)[3594], 8 June 1989; & JP-A-1 047 067
- PATENT ABSTRACTS OF JAPAN, vol. 9, no. 212 (E-339)[1935], 29 August 1985; & JP-A-60 074 470

## Description

The present invention relates to a method of producing capacitive elements for integrated circuits.

In densification of dynamic random access memories (DRAM), despite the minimized area per bit, a larger capacitance value per unit area is still required because it is difficult to decrease the required capacitance value of a capacitor for storing data because of the limitation that a certain resistivity against alpha rays is desired. A thinner insulating film for the capacitor may be a way to avoid the foregoing problem, but only a limited reduction of the insulating film thickness is possible. For a large capacity DRAM of four megabits or more, a method has been proposed in which the capacitance is obtained on the inside wall of an aperture provided in a substrate (trench capacitance) or the capacitance is obtained on the side wall of a capacitor electrode raised above a substrate (stack capacitance). Those methods, however, may not be applied for a DRAM of 64 megabits or more because they require too much depth or height. Thus, a method of employing laminated capacitive electrodes is proposed for the DRAM of 64 megabits or more in order to obtain the enlarged surface area of stack capacitance electrodes without increasing the height. An example of such a structure is "a memory cell having fin-type capacitors" proposed by T. Ema et al. at the "the International Electron Devices Meeting" in 1988, the Meeting Papers, p.592.

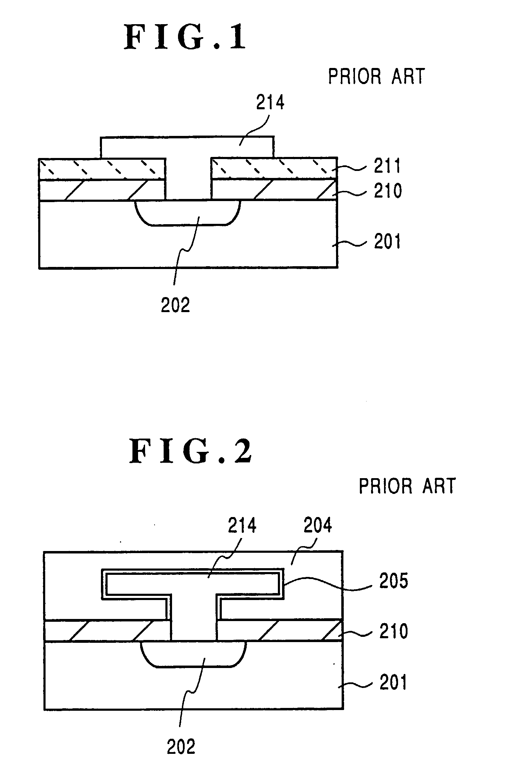

In Figure 1, implanting an impurity into a silicon substrate 201 provides a silicon active layer 202. A layer-to-layer insulating film 210 made of silicon nitride and a spacer 211 made of silicon dioxide are then sequentially deposited. A contact aperture is formed which reaches the active layer 202 and then there is provided a polysilicon capacitive electrode 214 extending through the contact aperture and forming a storage node electrode (a so-called fin) of a memory cell capacitor connected to the silicon active layer 202.

In Figure 2, the spacer 211 is selectively removed to expose the lower surface of the polysilicon capacitive electrode 214 and a capacitive insulating film 205 is formed on the entire exposed surface of the polysilicon capacitive electrode 214. A polysilicon capacitive electrode 204 is then formed by a vapour phase growth procedure so as to embed the capacitive insulating film 205 within the electrode 204, which acts as an opposing electrode to the polysilicon capacitive electrode 214 through the capacitive insulating film 205.

The polysilicon capacitive electrode 204 forms the cell-plate electrode of a memory-cell capacitor, the electrode 204 being commonly connected to all the cells of a memory to be held at a reference voltage. By this arrangement the polysilicon capacitive electrode 204 embraces the polysilicon capacitive electrode 214 from above and below so as to increase the capacitance. Further, the capacitive insulating film 205 and the polysilicon capacitive electrode 204 may be formed continuously so as to produce a capacitive insulating film of high quality.

However, in the conventional method hereinbefore described, a part of the electrode, during its production process, has no support thereunder and is thus suspended unstably in the atmosphere. This causes a problem of low mechanical strength during handling. A high grade of capacitive insulating film is required to produce a thin enough film if a narrower gap beneath the unsupported portion of the electrode is to be implemented, in order to ensure complete embedding with electrode material. The production process in that case is not as convenient as if a thicker film material and a wider gap are used, although this limits the possibilities for the shape of the electrode.

Prior published US patent no. US-A-4899203 describes a capacitive element for an integrated circuit which is made as follows. A first plate electrode and a first dielectric film are formed on a substrate, and then a contact hole is formed by photolithography through these layers to expose a high impurity concentration region of the substrate beneath. The surface of the device is then oxidised at between 800°C and 900°C to form insulating oxide layers at the edge of the first plate electrode exposed within the contact hole and on the exposed substrate at the base of the contact hole. The device is then etched by reactive ion etching to remove the latter layer of insulating oxide. A charge storage electrode is then deposited, covering the base and walls of the contact hole and overlapping the dielectric film around the contact hole. A second dielectric film is then formed over the whole device, followed by a second plate electrode. The first and second plate electrodes are electrically connected via an opening formed in the first and second dielectric films to one side of the charge storage electrode.

In this prior art method the first dielectric film is subjected, while exposed on the surface of the device, to photolithographic etching, to oxidation at 800°C to 900°C, and to reactive ion etching.

Japanese prior published patent application no. JP-A-2135771 describes a method for making a multilayered, laminated capacitive element. This method is similar to that for making the single-layer electrode illustrated in figures 1 and 2 as described above, except that the central charge storage electrode is formed by alternately depositing a succession of electrode layers and spacer layers so as to create a multi-finned charge storage electrode. The spacer layers are then removed and a dielectric film deposited on the charge storage electrode. This multi-finned structure is then embedded in electrode material which forms the second electrode of the capacitive element.

Japanese prior published patent application no. JP 59-231851 describes a method for making a capacitive element for a semiconductor memory cell. In this method a lower electrode layer, a Si₃N₄ film and an upper electrode layer are sequentially deposited on a substrate, the upper electrode layer having a central opening. A second Si₃N₄ film is then deposited over the upper electrode layer and the base and walls of the opening, an aperture is etched extending from the surface of the second Si₃N₄ film within the opening to the substrate, and a last electrode layer formed which covers the second Si₃N₄ film and fills the aperture, thus contacting the lower electrode layer and the substrate. In this method the second Si₃N₄ dielectric film is exposed, while on the surface of the device, to an etching process.

The invention provides a method for making a capacitive element as defined in the appendant independent claims, to which reference should now be made. Preferred features of the invention are defined in dependent subclaims.

The method of the invention may advantageously produce a capacitive element which has two electrodes, an A electrode and a B electrode, for use in an integrated circuit. At least part of the A electrode is constituted of first and second conductors. A part of the second conductor and a part of the B electrode are arranged respectively above and below each other, separated by a capacitive insulating film. A part of the first conductor is arranged below the B electrode, also separated from it by a capacitive insulating film. A further part of the first conductor is arranged below, and connected with, a portion of the second conductor to one side of the B electrode. The method preferably comprises the steps of forming the first conductor over a substrate, providing a first capacitive insulating film on its surface forming the B electrode over a substrate portion where the first conductor is not present and over a part of the first conductor, forming a second capacitive insulating film on an exposed surface of the first conductor and on the surface of the B electrode, forming the second conductor over a part of the B electrode and over at least a part of the first conductor, forming an aperture or a recess in a part of the region where the second conductor is formed directly over the first conductor so that the aperture or recess penetrates through the second conductor to reach the first conductor, and depositing a conductor on the inside wall of the aperture or recess.

In a method of production according to the invention, the laminated capacitive element may be obtained without a stage at which the electrode material is unstably suspended in the atmosphere. This may advantageously result in more convenient production of thinner electrodes, and so a larger capacitance value may be obtained than in the prior art by increasing the number of laminated electrodes within a limited height. Further, the capacitive insulating film and the electrode layer covering the insulating film may be formed continuously.

Preferred embodiments of a method of producing a capacitive element for integrated circuits according to the present invention will hereinafter be fully described in detail with reference to the accompanying drawings.
Figure 1 is a sectional view of an intermediate stage in the manufacture of a capacitive element illustrative of a conventional method of producing a capacitive element for an integrated circuit;
Figure 2 is a sectional view of the completed capacitive element of Figure 1, illustrative of a conventional device for a capacitive element for an integrated circuit;
Figure 3 is a sectional view of a capacitive element for an integrated circuit formed by a method according to a first embodiment of the invention;
Figure 4 is a sectional view of a capacitive element formed by a method according to a second embodiment of the invention;
Figure 5 is a sectional view of a capacitive element formed by a method according to a third embodiment of the invention;
Figure 6 is a sectional view of a capacitive element formed by a method according to a fourth embodiment of the invention;
Figure 7 is a sectional view of a portion of the capacitive element of Fig. 6 illustrating a first connection of the cell plate electrodes; and
Figure 8 is a sectional view of a portion of the capacitive element of Fig. 6 illustrating a second, alternative, connection of the cell plate electrodes.

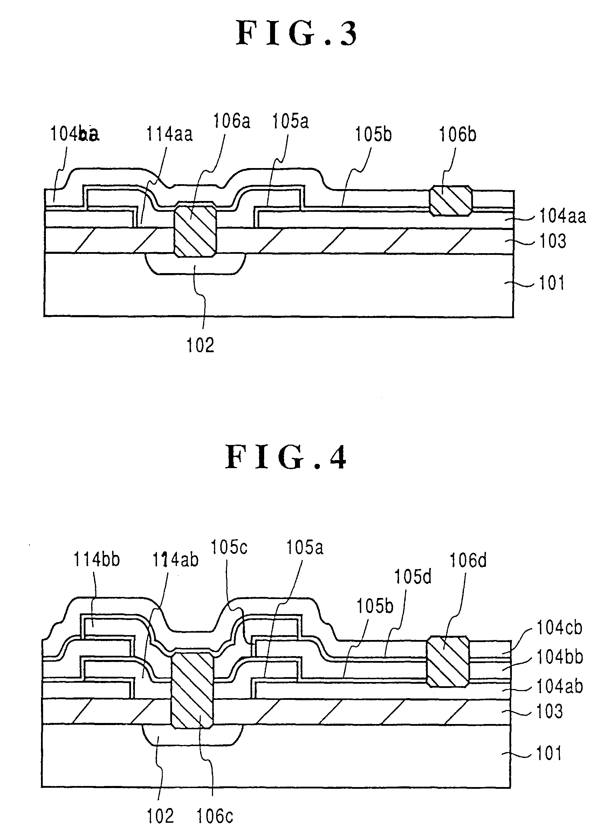

In the first embodiment of Figure 3, a polysilicon capacitive electrode 114aa constitutes a storage node electrode and polysilicon capacitive electrodes 104aa and 104ba provide cell plate electrodes.

A silicon active layer 102 is formed on a silicon substrate 101 in a region where a layer-to-layer insulating film 103 covers the entire surface of the substrate. The layer-to-layer insulating film 103 is conventionally a silicon nitride film, but in the invention is not limited to that material. A polysilicon film is then formed by deposition to produce a polysilicon capacitive electrode 104aa and a first capacitive insulating film 105a is formed on the entire surface. The polysilicon capacitive electrode 104aa is formed on the whole region of the device except over at least a part of the silicon active layer 102. The capacitive insulating film 105a is formed on the thus exposed surface of the layer-to-layer insulating film 103 and in the subsequent steps of the process the capacitive insulating layer 105a remains in place, without being removed, but the residue of the capacitive insulating layer 105a on the exposed region of the insulating film 103 has substantially no relationship with the invention and is therefore omitted in all the drawings. A polysilicon film is then deposited to form the polysilicon capacitive electrode 114aa, covering an area which includes the region over the silicon active layer 102. The polysilicon capacitive electrode 114aa must then be shaped into a form having an aperture through which a polysilicon plug 106a may pass without contacting the polysilicon capacitive electrode 104aa.

The aperture is provided by etching to reach the silicon active layer 102 through the polysilicon capacitive electrode 114aa. A polysilicon plug 106a is inserted into the aperture to bring the silicon active layer 102 into electrical contact with the polysilicon capacitive electrode 114aa. Polysilicon or other materials, such as tungsten, may be employed for the plug material. The portion of the first capacitive insulating film 105a which is not coated with the polysilicon capacitive electrode 114aa is then removed and a second capacitive insulating film 105b is formed on the entire surface of the device. Thereafter, a polysilicon film is deposited on the entire surface to produce a polysilicon capacitive electrode 104ba.

In the region where the polysilicon capacitive electrode 104aa lies underneath the polysilicon capacitive electrode 104ba and the capacitive insulating film 105b, an aperture is provided by etching to reach the polysilicon capacitive electrode 104aa through the polysilicon capacitive electrode 104ba. The aperture is filled by a polysilicon plug 106b to connect the polysilicon electrode 104aa with the polysilicon capacitive electrode 104ba. The aperture may reach the layer-to-layer insulating film 103.

In the embodiment, two connections by means of plugs formed in apertures provided between conductive layers may be made, i.e. one for forming the storage node electrode and another for forming the cell plate electrode.

The second embodiment as shown in FIG. 4 is an advanced modification of the first embodiment where the storage node electrode is formed of two layers, a polysilicon capacitive electrode 114ab and a polysilicon capacitive electrode 114bb, and the cell plate electrode comprises three layers, the polysilicon capacitive electrodes 104ab and 104bb and a polysilicon capacitive electrode 104cb.

The polysilicon capacitive electrodes 104ab and 114ab are formed by the same method as the polysilicon capacitive electrodes 104aa and 114aa of the first embodiment. The capacitive insulating film 105a is then removed using the polysilicon capacitive electrode 114ab as a mask, and the second capacitive insulating film 105b is formed on the entire surface. The polysilicon capacitive electrode 104bb is then formed under the same limitation as the polysilicon capacitive electrode 104ab and a third capacitive insulating film 105c is formed over the entire surface. The polysilicon capacitive electrode 114bb is then formed. The polysilicon capacitive electrode 114bb is formed under the same limitation as in the polysilicon capacitive electrode 114ab.

An aperture is provided by etching to reach the silicon active layer 102 by penetrating the polysilicon capacitive electrodes 114bb and 114 ab from the surface of the polysilicon capacitive electrode 114bb. The aperture is filled with a polysilicon plug 106c to connect the silicon active layer 102 to the polysilicon capacitive electrodes 114ab and 114bb. The exposed portion of the third capacitive insulating film 105c is then removed and a fourth capacitive insulating film 105d formed on the entire surface. Thereafter, a polysilicon capacitive electrode 104cb is formed on the entire surface.

In a region where the polysilicon capacitive electrode 104bb is formed underneath the polysilicon capacitive electrode 104cb (separated by the capacitive insulating film 105d) and the polisilicon capacitive electrode 104ab is formed underneath the polisilicon capacitive electrode 104bb (separated by the capacitive insulating film 105b), an aperture is provided by etching to reach the polysilicon capacitive electrode 104ab by penetrating the polysilicon capacitive electrodes 104cb and 104bb from the surface of the polysilicon capacitive electrode 104cb. A polysilicon plug 106d is formed in the aperture to connect the polysilicon capacitive electrodes 104ab, 104bb and 104cb to each other.

The embodiment provides a polysilicon capacitive electrode having three layers connected by a single polysilicon plug to provide the cell plate electrode. Methods of producing electrodes having more layers are obvious in view of this embodiment.

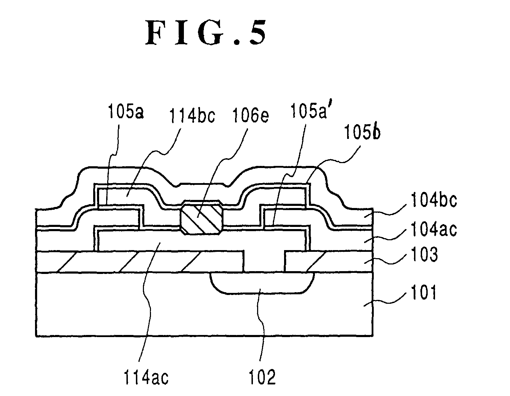

In the third embodiment in FIG. 5, an aperture is provided in the layer-to-layer insulating film 103 to reach the active layer 102 and a polysilicon capacitive electrode 114ac is formed in a region including the aperture. Thereafter, the following steps are carried out in sequence; formation of the first capacitive insulating film 105al, formation of a polysilicon capacitive eectrode 104ac, selective removal of the capacitive insulating film 105al, formation of the second capacitive insulating film 105a, formation of a polysilicon capacitive electrode 114bc, formation a polysilicon plug 106e for connecting the polysilicon capacitive electrode 114bc to the polysilicon capacitive electrode 114ac, selective removal of the capacitive insulating film 105a, formation of the third capacitive insulating film 105b and formation of the polysilicon capacitive electrode 104bc. Excess boring of the aperture for receiving the polysilicon plug 106e is allowable to a small extent according to the embodiment. The same method as for the first embodiment may be applied to this embodiment for providing the plug which connects the polysilicon capacitive electrodes 104ac and 104bc to each other to produce the cell plate electrode.

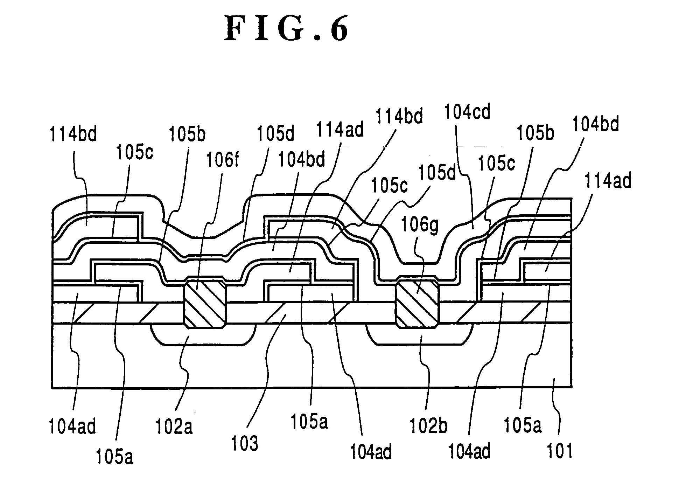

The fourth embodiment of FIGS. 6 to 8 includes an example in which the invention is applied to "the memory cell structure with an increased capacitance per unit area by laminating adjacent storage node electrodes with each other" proposed by Inoue et al in "the International Electron Devices Meeting" in 1989, the Meeting Papers, p.31.

In FIG. 6, two adjacent storage node electrodes laminated with each other include respectively a polysilicon capacitive electrode 114ad connected to a silicon active layer 102a through a polysilicon plug 106f, and a polysilicon capacitive electrode 114bd connected to a silicon active layer 102b through a polysilicon plug 106g. The cell plate electrode is constituted of polysilicon capacitive electrodes 104ad, 104bd and 104cd.

A method of production according to this embodiment includes the steps of forming the polysilicon capacitive electrode 104ad, the first capacitive insulating film 105a, the polysilicon capacitive electrode 114ad, the polysilicon plug 106f, the second capacitive insulating film 105b and the polysilicon capacitive electrode 104bd as in the first embodiment, removing the polysilicon capacitive electrodes 104bd and 104ad from a region including at least a part of the region just above the silicon active layer 102b, forming the third capacitive insulating film 105c, forming the polysilicon capacitive electrode 114bd, forming the polysilicon plug 106g, selectively removing the capacitive insulating film 105c, forming the fourth capacitive insulating film 105d and forming the polysilicon capacitive electrode 104cd. Thus, the structure as shown in Figure 6 may be obtained.

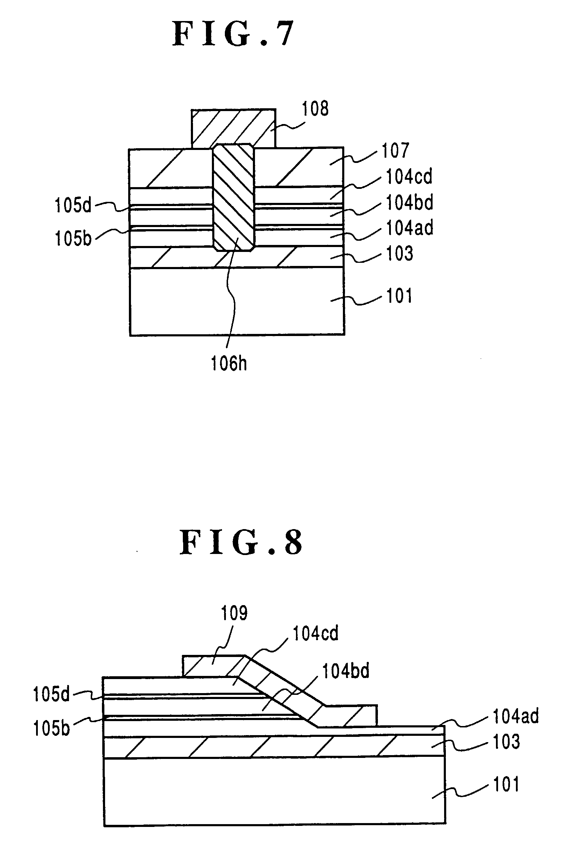

In a first method as shown in FIG. 7, a second layer-to-layer insulating film 107 is formed on the entire surface. An aperture, which reaches from the layer-to-layer insulating film 107 at least as for as the polysilicon capacitive electrode 104ad, is then formed in a region in which the polysilicon capacitive electrodes 104cd, 104bd and 104ad are laminated with the capacitive insulating films 105d and 105b. A polysilicon plug 106h is formed, filling the aperture, to connect the polysilicon capacitive electrodes 104cd, 104bd and 104ad to each other. Finally, an aluminium electrode 108 is formed in connection with the polysilicon plug 106h so as to obtain the structure shown in FIG. 7.

A second method is shown in FIG. 8. Here, an interconnection 109 made of polysilicon is provided at an obliquely cut region where the polysilicon capacitive electrodes 104cd, 104bd and 104ad are laminated with the capacitive insulating films 105d and 105b so that the polysilicon capacitive electrodes 104cd, 104bd and 104ad are connected with each other so as to obtain the structure shown in Figure 8.

The methods of interconnection of the cell plate electrodes illustrated in Figures 7 and 8 in relation to the fourth embodiment of the invention may clearly be applied to the other embodiments.

As hereinbefore fully described, in accordance with the embodiments, processes are provided for producing capacitive elements of various shapes in which layered storage node electrodes are formed without a step in which the electrodes are in an unstable condition in which the storage node electrode is partially suspended in the air without support thereunder during the production operation. This alleviates considerably the limitations of thickness and size of the electrode layers which can be produced, thus enabling an increase in the number of layers which can be laminated and a larger capacitance value per unit area. In addition, the advantages of the conventional method, in which the capacitive insulating films and the electrode layers embracing the films are continuously formed, are satisfactorily maintained.

## Claims

1. A method for making a capacitive element over a surface of a semiconductor substrate (101) having an active region (102) therein, comprising the following steps;
(A) : forming a first layer (104aa, 104ab, 104ac, 104ad) of an A electrode (104) of the capacitive element over the semiconductor substrate surface, the first layer being electrically insulated from the substrate, and having an opening of a first width defined therein;
(B): forming a first dielectric film (105a) on the exposed surface of the first layer of the A electrode;
(C) : forming a first layer (114aa, 114ab, 114bc, 114ad, 114bd) of a B electrode (114) both within the opening in the first layer of the A electrode and extending laterally so as to overlap the first layer of the A electrode around the opening, the first layers of the A and B electrodes being separated by the first dielectric film;
(D): forming an aperture having a second width less than the first width extending from the exposed surface of the B electrode through the opening into either the active region of the substrate or a conductive layer (114ac) in electrical contact with the active region of the substrate;
(E) : filling the aperture with a conductive material (106a, 106c, 106e, 106f, 106g) so as to electrically connect the B electrode to the active region;
(F) : forming a second dielectric film (105b) over the exposed surfaces of the B electrode and the conductive material filling the aperture; and
(G): forming a second layer (104ba, 104bb, 104bc, 104bd) of the A electrode over the second dielectric layer so as to cover the B electrode and to overlap at least a portion of the first layer of the A electrode, an electrical connection (106b, 106d, 106h, 109) being made between the first and second layers of the A electrode.

2. A method according to claim 1, in which in step (B) the first dielectric film is also formed on the base of the opening.

3. A method according to claim 1 or 2, in which before step (F) the first dielectric film is stripped from the exposed surface of the first layer of the A electrode, using the first layer of the B electrode as a mask.

4. A method according to claim 1, 2 or 3 for forming two adjacent capacitive elements on the same substrate, in which the first layers (114ad, 114bd) of the B electrodes of the capacitive elements overlap each other, being separated by an interleaved layer (104bd) of the A electrode, the A electrode being common to both capacitive elements.

5. A method according to any preceding claim, in which the aperture formed in step (D) extends into a conductive layer (114ac) in electrical contact with the active region of the substrate, the conductive layer being insulated from the substrate except at the contact with the active region and separated from an overlying portion of the first layer (104ac) of the A electrode by a dielectric film (105a'), the first layer of the A electrode being formed in step (A) over the conductive layer with the opening therein positioned over the conductive layer, so that the conductive layer forms a base layer of the B electrode in the completed capacitive element.

6. A method for making a capacitive element over a surface of a semiconductor substrate (101) having an active region (102) therein, comprising the following steps;
(A) : forming a first layer (104ab) of an A electrode (104) of the capacitive element over the semiconductor substrate surface, the first layer being electrically insulated from the substrate, and having an opening of a first width defined therein;
(B) : forming a first dielectric film (105a)on the exposed surface of the first layer of the A electrode;
(C) : forming a first layer (114ab) of a B electrode (114) both within the opening in the first layer of the A electrode and extending laterally so as to overlap the first layer of the A electrode around the opening, the first layers of the A and B electrodes being separated by the first dielectric film;
(D) : forming a further dielectric film (105b) over the exposed surface of the first or previous layer of the B electrode;
(E) : forming a further layer (104bb) of the A electrode over the first or previous layer (114ab) of the B electrode and over at least an adjacent portion of the first or previous layer (104ab) of the A electrode, the further layer of the A electrode being spaced from the first or previous layer of the B electrode by the uppermost dielectric film and having an opening defined therein so that a portion of the first or previous layer of the B electrode, covered by the uppermost dielectric film, is exposed at the base of the opening;
(F) : forming a further dielectric film over the exposed surface of the further layer of the A electrode;
(G) : forming a further layer (114bb) of the B electrode both within the opening of the further layer of the A electrode and extending laterally so as to overlap the further layer of the A electrode around the opening, the further layers of the A and B electrodes being separated by the uppermost dielectric film;
repeating steps (D) to (G) if and as required until;
(H) : forming an aperture having a second width less than the first width extending from the exposed surface of the B electrode through the opening into either the active region of the substrate or a conductive layer (114ac) in electrical contact with the active region of the substrate;
(I) : filling the aperture with a conductive material (106c) so as to electrically connect the B electrode to the active region;
(J) : forming a last dielectric film (105d) over the exposed surfaces of the B electrode and the conductive material filling the aperture; and
(K) : forming a last layer (104cb) of the A electrode over the last dielectric layer so as to cover the B electrode and to overlap at least an adjacent portion of the previous layer of the A electrode, an electrical connection (106d, 106h, 109) being made between all the layers of the A electrode.

7. A method according to claim 6, in which in step (B) or (F) the first or further dielectric film is also formed on the layer at the base of the opening.

8. A method according to claim 6 or 7, in which before step (D) or (J) the uppermost dielectric film is stripped from the exposed surface of the first or previous layer of the A electrode, using the first or further layer of the B electrode as a mask.

9. A method according to claim 6, 7 or 8 for forming two adjacent capacitive elements on the same substrate, in which layers (114ad, 114bd) of the B electrodes of the capacitive elements overlap each other, each pair of overlapping layers being separated by a layer (104bd) of the A electrode, the A electrode being common to both capacitive elements.

10. A method according to any of claims 6 to 9, in which the aperture formed in step (H) extends into a conductive layer (114ac) in electrical contact with the active region of the substrate, the conductive layer being insulated from the substrate except at the contact with the active region and separated from an overlying portion of the first layer (104ac) of the A electrode by a dielectric film (105a'), the first layer of the A electrode being formed in step (A) over the conductive layer with the opening therein positioned over the conductive layer, so that the conductive layer forms a base layer of the B electrode in the completed capacitive element.

## Patentansprüche

1. Verfahren zum Herstellen eines kapazitiven Elements über einer Oberfläche eines Halbleitersubstrats (101) mit einem darin befindlichen aktiven Bereich (102), das die folgenden Schritte aufweist:
(A) : Ausbilden einer ersten Schicht (104aa, 104ab, 104ac, 104ad) einer A-Elektrode (104) des kapazitiven Elements über einer Halbleitersubstratoberfläche, wobei die erste Schicht von dem Substrat elektrisch isoliert ist, und die eine darin bestimmte Aussparung einer ersten Breite besitzt;
(B) : Ausbilden eines ersten dielektrischen Films (105a) auf der freigelegten Oberfläche der ersten Schicht der A-Elektrode;
(C) : Ausbilden einer ersten Schicht (114aa, 114ab, 114bc, 114ad, 114bd) einer B-Elektrode (114), die sich sowohl innerhalb der Aussparung in der ersten Schicht der A-Elektrode befindet als auch seitlich erstreckt, um die erste Schicht der A-Elektrode um die Aussparung herum zu überlappen, wobei die ersten Schichten der A- und B-Elektroden durch den ersten dielektrischen Film getrennt sind;
(D) : Ausbilden einer Öffnung mit einer zweiten Breite, die geringer ist als die erste Breite, die sich von der freigelegten Oberfläche der B-Elektrode durch die Aussparung in entweder den aktiven Bereich des Substrats oder eine leitende Schicht (114ac) in elektrischem Kontakt mit dem aktiven Bereich des Substrats erstreckt;
(E) : Füllen der Öffnung mit einem leitenden Material (106a, 106c, 106e, 106f, 106g), um die B-Elektrode mit dem aktiven Bereich elektrisch zu verbinden;
(F) : Ausbilden eines zweiten dielektrischen Films (105b) über den freigelegten Oberflächen der B-Elektrode und dem die Öffnung füllenden leitenden Material; und
(G) : Ausbilden einer zweiten Schicht (104ba, 104bb, 104bc, 104bd) der A-Elektrode über der zweiten dielektrischen Schicht, um die B-Elektrode zu bedecken und um mindestens einen Abschnitt der ersten Schicht der A-Elektrode zu überlappen, wobei zwischen der ersten und der zweiten Schicht der A-Elektrode eine elektrische Verbindung (106b, 106d, 106h, 109) hergestellt wird.

2. Verfahren nach Anspruch 1, bei dem in Schritt (B) der erste dielektrische Film ebenfalls auf der Bodenfläche der Aussparung ausgebildet wird.

3. Verfahren nach Anspruch 1 oder 2, bei dem vor Schritt (F) der dielektrische Film von der freigelegten Oberfläche der ersten Schicht der A-Elektrode abgezogen wird, wobei die erste Schicht der B-Elektrode als eine Maske verwendet wird.

4. Verfahren nach Anspruch 1, 2 oder 3 zum Ausbilden zweier benachbarter kapazitiver Elemente auf dem gleichen Substrat, bei dem die ersten Schichten (114ad, 114bd) der B-Elektroden der kapazitiven Elemente einander überlappen und durch eine Zwischenschicht (104bd) der A-Elektrode getrennt sind, wobei die A-Elektrode den beiden kapazitiven Elementen gemeinsam ist.

5. Verfahren nach einem der vorstehenden Ansprüche, bei dem die in Schritt (D) ausgebildete Öffnung sich in eine leitende Schicht (114ac) erstreckt, die sich in elektrischem Kontakt mit dem aktiven Bereich des Substrats befindet, wobei die leitende Schicht außer an dem Kontakt mit dem aktiven Bereich von dem Substrat isoliert ist und von einem darüberliegenden Abschnitt der ersten Schicht (104ac) der A-Elektrode durch einen dielektrischen Film (105a') getrennt ist, wobei die erste Schicht der A-Elektrode in Schritt (A) über der leitenden Schicht mit der Aussparung ausgebildet ist, die in ihr über der leitenden Schicht angeordnet ist, so daß die leitende Schicht in dem vollständigen kapazitiven Element eine Basisschicht der B-Elektrode bildet.

6. Verfahren zum Herstellen eines kapazitiven Elements über einer Oberfläche eines Halbleitersubstrats (101) mit einem darin befindlichen aktiven Bereich (102), das die folgenden Schritte aufweist:
(A) : Ausbilden einer ersten Schicht (104ab) einer A-Elektrode (104) des kapazitiven Elements über der Halbleitersubstratoberfläche, wobei die erste Schicht von dem Substrat elektrisch isoliert ist, und die eine darin bestimmte Aussparung einer ersten Breite besitzt;
(B) : Ausbilden eines ersten dielektrischen Films (105a) auf der freigelegten Oberfläche der ersten Schicht der A-Elektrode;
(C) : Ausbilden einer ersten Schicht (114ab) einer B-Elektrode (114), die sich sowohl innerhalb der Aussparung in der ersten Schicht der A-Elektrode befindet als auch seitlich erstreckt, um die erste Schicht der A-Elektrode um die Aussparung herum zu überlappen, wobei die ersten Schichten der A- und B-Elektroden durch den ersten dielektrischen Film getrennt sind;
(D) : Ausbilden eines weiteren dielektrischen Films (105b) über der freigelegten Oberfläche der ersten oder vorausgehenden Schicht der B-Elektrode;
(E) Ausbilden einer weiteren Schicht (104bb) der A-Elektrode über der ersten oder vorausgehenden Schicht (114ab) der B-Elektrode und über mindestens einem benachbarten Abschnitt der ersten oder vorausgehenden Schicht (104ab) der A-Elektrode, wobei die weitere Schicht der A-Elektrode durch den obersten dielektrischen Film von der ersten oder vorausgehenden Schicht der B-Elektrode beabstandet ist, und die eine darin bestimmte Aussparung besitzt, so daß ein Abschnitt der ersten oder vorausgehenden Schicht der B-Elektrode, die von dem obersten dielektrischen Film bedeckt ist, an der Bodenfläche der Aussparung freigelegt ist;
(F) Ausbilden eines weiteren dielektrischen Films über der freigelegten Oberfläche der weiteren Schicht der A-Elektrode;
(G) : Ausbilden einer weiteren Schicht (114bb) der B-Elektrode, die sich sowohl innerhalb der Aussparung der weiteren Schicht der A-Elektrode befindet als auch seitlich erstreckt, um die weitere Schicht der A-Elektrode um die Aussparung herum zu überlappen, wobei die weiteren Schichten der A- und B-Elektroden durch den obersten dielektrischen Film getrennt sind;
Wiederholen der Schritte (D) bis (G), falls erforderlich und wie gefordert, bis zum:
(H) : Ausbilden einer Öffnung mit einer zweiten Breite, die geringer ist als die erste Breite, die sich von der freigelegten Oberfläche der B-Elektrode durch die Aussparung in entweder den aktiven Bereich des Substrats oder eine leitende Schicht (114ac) in elektrischem Kontakt mit dem aktiven Bereich des Substrats erstreckt;
(I) : Füllen der Öffnung mit einem leitenden Material (106c), um die B-Elektrode mit dem aktiven Bereich elektrisch zu verbinden;
(J) : Ausbilden eines letzten dielektrischen Films (105d) über der freigelegten Oberfläche der B-Elektrode und dem die Öffnung füllenden leitenden Material; und
(K) : Ausbilden einer letzten Schicht (104cb) der A-Elektrode über der letzten dielektrischen Schicht, um die B-Elektrode zu bedecken und um mindestens einen benachbarten Abschnitt der vorausgehenden Schicht der A-Elektrode zu überlappen, wobei zwischen allen Schichten der A-Elektrode eine elektrische Verbindung (106d, 106h, 109) hergestellt wird.

7. Verfahren nach Anspruch 6, bei dem in Schritt (B) oder (F) der erste oder weitere dielektrische Film ebenfalls auf der Schicht an der Bodenfläche der Aussparung ausgebildet ist.

8. Verfahren nach einem der Ansprüche 6 oder 7, bei dem vor Schritt (D) oder (J) der oberste dielektrische Film von der freigelegten Oberfläche der ersten oder vorausgehenden Schicht der A-Elektrode abgezogen wird, wobei die erste oder weitere Schicht der B-Elektrode als eine Maske verwendet wird.

9. Verfahren nach einem der Ansprüche 6, 7 oder 8 zum Ausbilden zweier benachbarter kapazitiver Elemente auf dem gleichen Substrat, bei dem Schichten (114ad, 114bd) der B-Elektroden der kapazitiven Elemente einander überlappen, wobei jedes Paar der überlappenden Schichten durch eine Schicht (104bd) der A-Elektrode getrennt ist und die A-Elektrode den beiden kapazitiven Elementen gemeinsam ist.

10. Verfahren gemäß einem der Ansprüche 6 bis 9, bei dem die in Schritt (H) ausgebildete Öffnung sich in eine leitende Schicht (114ac) erstreckt, die sich in elektrischem Kontakt mit dem aktiven Bereich des Substrats befindet, wobei die leitende Schicht außer an dem Kontakt mit dem aktiven Bereich von dem Substrat isoliert ist und von einem überlappenden Abschnitt der ersten Schicht (104ac) der A-Elektrode durch einen dielektrischen Film (105a') getrennt ist, wobei die erste Schicht der A-Elektrode in Schritt (A) über der leitenden Schicht mit einer Aussparung ausgebildet ist, die in ihr über der leitenden Schicht angeordnet ist, so daß die leitende Schicht bei dem vollständigen kapazitiven Element eine Basisschicht der B-Elektrode bildet.

## Revendications

1. Procédé de fabrication d'un élément capacitif sur la surface d'un substrat semi-conducteur (101) comportant une région active (102), comprenant les étapes suivantes consistant à :
(A) : former une première couche (104aa, 104ab, 104ac, 104ad) d'une électrode A (104) de l'élément capacitif sur la surface du substrat semi-conducteur, la première couche étant électriquement isolée du substrat, et dans laquelle une ouverture d'une première largeur est définie ;
(B) : former un premier film diélectrique (105a) sur la surface exposée de la première couche de l'électrode A ;
(C) : former une première couche (114aa, 114ab, 114bc, 114ad, 114bd) d'une électrode B (114) à la fois dans l'ouverture dans la première couche de l'électrode A et s'étendant latéralement afin de recouvrir la première couche de l'électrode A autour de l'ouverture, les premières couches des électrodes A et B étant séparées par le premier film diélectrique ;
(D) : former une ouverture ayant une seconde largeur inférieure à la première largeur s'étendant de la surface exposée de l'électrode B à travers l'ouverture dans soit la région active du substrat soit une couche conductrice (114ac) en contact électrique avec la région active du substrat ;
(E) : remplir l'ouverture avec un matériau conducteur (106a, 106c, 106e, 106f, 106g) afin de connecter électriquement l'électrode B à la région active ;
(F) : former un second film diélectrique (105b) sur les surfaces exposées de l'électrode B et le matériau conducteur remplissant l'ouverture ; et
(G) : former une seconde couche (104ba, 104bb, 104bc, 104bd) de l'électrode A sur la seconde couche diélectrique afin de recouvrir l'électrode B et de recouvrir au moins une partie de la première couche de l'électrode A, une connexion électrique (106b, 106d, 106h, 109) étant réalisée entre les première et seconde couches de l'électrode A.

2. Procédé selon la revendication 1, dans lequel lors de l'étape (B), le premier film diélectrique est également formé sur la base de l'ouverture.

3. Procédé selon la revendication 1 ou 2, dans lequel, avant l'étape (F), le premier film diélectrique est retiré de la surface exposée de la première couche de l'électrode A, en utilisant la première couche de l'électrode B comme un masque.

4. Procédé selon la revendication 1, 2 ou 3 pour former deux éléments capacitifs adjacents sur le même substrat, dans lequel les premières couches (114ad, 114bd) des électrodes B des éléments capacitifs se chevauchent, en étant séparés par une couche interposée (104bd) de l'électrode A, l'électrode A étant commune aux deux éléments capacitifs.

5. Procédé selon l'une quelconque des revendications précédentes, dans lequel l'ouverture formée lors de l'étape (D) s'étend dans une couche conductrice (114ac) en contact électrique avec la région active du substrat, la couche conductrice étant isolée du substrat sauf au niveau du contact avec la région active et séparée d'une partie chevauchante de la première couche (104ac) de l'électrode A par un film diélectrique (105a'), la première couche de l'électrode A étant formée lors de l'étape (A) sur la couche conductrice avec l'ouverture à l'intérieur positionnée sur la couche conductrice, de telle sorte que la couche conductrice forme une couche de base de l'électrode B dans l'élément capacitif achevé.

6. Procédé pour fabriquer un élément capacitif sur une surface d'un substrat semi-conducteur (101) comportant une région active (102), comprenant les étapes suivantes consistant à :
(A) : former une première couche (104ab) d'une électrode A (104) de l'élément capacitif sur la surface du substrat semi-conducteur, la première couche étant électriquement isolée du substrat, et dans laquelle une ouverture d'une première largeur est définie ;
(B) : former un premier film diélectrique (105a) sur la surface exposée de la première couche de l'électrode A ;
(C) : former une première couche (114ab) d'une électrode B (114) à la fois dans l'ouverture dans la première couche de l'électrode A et s'étendant latéralement afin de chevaucher la première couche de l'électrode A autour de l'ouverture, les premières couches des électrodes A et B étant séparées par le premier film diélectrique ;
(D) : former un film diélectrique supplémentaire (105b) sur la surface exposée de la première couche ou couche précédente de l'électrode B ;
(E) : former une couche supplémentaire (104bb) de l'électrode A sur la première couche ou couche précédente (114ab) de l'électrode B et sur au moins une partie adjacente de la première couche ou couche précédente (104ab) de l'électrode A, la couche supplémentaire de l'électrode A étant espacée de la première couche ou couche précédente de l'électrode B par le film diélectrique le plus en surface et ayant une ouverture définie à l'intérieur de telle sorte qu'une partie de la première couche ou couche précédente de l'électrode B, recouverte par le film diélectrique le plus en surface, est exposée à la base de l'ouverture ;
(F) : former un film diélectrique supplémentaire sur la surface exposée de l'autre couche de l'électrode A ;
(G) : former une couche supplémentaire (114bb) de l'électrode B à la fois à l'intérieur de la couche supplémentaire de l'électrode A et s'étendant latéralement afin de chevaucher la couche supplémentaire de l'électrode A autour de l'ouverture, les couches supplémentaires des électrodes A et B étant séparées par le film diélectrique le plus en surface ;
répéter les étapes (D) à (G) si et comme nécessaire jusqu'à ce qu'à (l'étape qui consiste à ) :
(H) : former une ouverture ayant une seconde largeur inférieure à la première largeur s'étendant depuis la surface exposée de l'électrode B à travers l'ouverture dans soit la région active du substrat soit une couche conductrice (114ac) en contact électrique avec la région active du substrat ;
(I) : remplir l'ouverture avec un matériau conducteur (106c) afin de connecter électriquement l'électrode B à la région active ;
(J) : former un dernier film diélectrique (105d) sur les surfaces exposées de l'électrode B et le matériau conducteur remplissant l'ouverture ; et
(K) former une dernière couche (104cb) de l'électrode A sur la dernière couche diélectrique afin de recouvrir l'électrode B et pour chevaucher au moins une partie adjacente de la couche précédente de l'électrode A, une connexion électrique (106d, 106h, 109) étant réalisée entre toutes les couches de l'électrode A.

7. Procédé selon la revendication 6, dans lequel lors de l'étape (B) ou (F), le premier ou le film diélectrique supplémentaire est également formé sur la couche à la base de l'ouverture.

8. Procédé selon la revendication 6 ou 7, dans lequel, avant l'étape (D) ou (J), le film diélectrique le plus en surface est retiré de la surface exposée de la première couche ou couche précédente de l'électrode A, en utilisant la première couche ou la couche supplémentaire de l'électrode B comme un masque.

9. Procédé selon la revendication 6, 7 ou 8 destiné à former deux éléments capacitifs adjacents sur le même substrat, dans lequel les couches (114ad, 114bd) de l'électrode B des éléments capacitifs se chevauchent les unes les autres, chaque paire de couches se chevauchant étant séparée par une couche (104bd) de l'électrode A, l'électrode A étant commune aux deux éléments capacitifs.

10. Procédé selon l'une quelconque des revendications 6 à 9, dans lequel l'ouverture formée lors de l'étape (H) s'étend dans une couche conductrice (114ac) en contact électrique avec la région active du substrat, la couche conductrice étant isolée du substrat sauf au niveau du contact avec la région active et séparée d'une partie chevauchante de la première couche (104ac) de l'électrode A par un film diélectrique (105a'), la première couche de l'électrode A étant formée lors de l'étape (A) sur la couche conductrice avec l'ouverture à l'intérieur positionnée sur la couche conductrice, de telle sorte que la couche conductrice forme une couche de base de l'électrode B dans l'élément capacitif achevé.
